# EUROPÄISCHE PATENTANMELDUNG

(11) **EP 1 524 892 A2**
(43) Veröffentlichungstag der Anmeldung: **20.04.2005**
(21) Anmeldenummer: 04022552.6
(22) Anmeldetag: 22.09.2004
(51) Int. Cl.: H05K 7/20

(54) **Betriebsschaltung für Lampe mit Kühlkörper**

(30) Priorität: 14.10.2003 DE 10348421
(71) Anmelder: Patent-Treuhand-Gesellschaft für Elektrische Glühlampen mbH, 81543 München (DE)
(72) Erfinder: Lecheler, Reinhard, 86633 Neuburg/Donau (DE); Schallmoser, Oskar, 85521 Ottobrunn (DE)

(57) **Zusammenfassung**

Die Erfindung betrifft eine Schaltung zum Betreiben einer Lampe mit einem zu kühlenden Bauelement 4 und einem Kühlkörper 6, 6', der mit einer Schaltungsplatine 1 einen Winkel von 10° - 70° einschließt.

## Beschreibung

### Technisches Gebiet

Die vorliegende Erfindung betrifft eine elektrische Schaltung zum Betreiben einer Lampe, die einen Kühlkörper aufweist.

### Stand der Technik

Es ist bekannt, in Betriebsschaltungen für Lampen solche elektronische Bauelemente, die im Betrieb in erheblichem Umfang Betriebswärme erzeugen, etwa Leistungstransistoren, durch Kühlkörper zu kühlen. Dabei handelt es sich konventioneller Weise i. d. R. um Metallblechkonstruktionen, die entweder durch eine Kopplung mit einer Gehäusewand die abzuführende Wärme auf das Gehäuse übertragen oder - ohne Gehäusekontakt - durch Abgabe der Wärme an die Umgebung durch Wärmeleitung und -strahlung kühlen. Die Kühlkörper können dabei an dem Bauelement gehalten sein, an dem Gehäuse der Schaltung gehalten sein und/oder auch auf einer Schaltungsplatine gehalten sein, auf der das Bauelement selbst montiert ist.

### Darstellung der Erfindung

Der Erfindung liegt das technische Problem zugrunde, eine hinsichtlich des Kühlkörpers für wärmeentwickelnde Bauelemente verbesserte elektrische Betriebsschaltung für Lampen anzugeben.

Die Erfindung richtet sich auf eine elektrische Schaltung zum Betreiben einer Lampe, welche Schaltung aufweist: zumindest ein elektronisches Bauelement, das im Betrieb Betriebswärme erzeugt, eine Schaltungsplatine, auf der das elektronische Bauelement montiert ist, und einen Kühlkörper zum Ableiten der Betriebswärme aus dem elektronischen Bauelement, wobei das elektronische Bauelement flächig an einer Anlagefläche des Kühlkörpers anliegt, dadurch gekennzeichnet, dass die Anlagefläche mit der Schaltungsplatine einen Winkel von 10° - 70° einschließt,
sowie auf ein entsprechendes Verfahren zum Montieren des Bauelements in der elektrischen Schaltung.

Die Grundidee der Erfindung besteht darin, die Anlagefläche des Kühlkörpers, die i. d. R. einer der Hauptseiten eines aus Metallblech bestehenden Kühlkörpers entspricht, nicht wie konventioneller Weise senkrecht oder parallel zur Platinenebene auszurichten sondern dazu anzuwinkeln. Als Winkel kommen dabei deutlich von 0° und von 90° verschiedene Winkel in Betracht, weswegen von einem Bereich von 10° - 70° ausgegangen wird. Es wird also auf den zwischen der Anlagefläche und einer zu der Schaltungsplatine parallelen Ebene eingeschlossenen spitzen Winkel Bezug genommen. Dabei sind aber sowohl Ausführungsformen umfasst, bei denen die Anlagefläche auf der von der Schaltungsplatine weggewandten als auch auf der der Schaltungsplatine zugewandten Seite des Kühlkörpers liegt.

Es hat sich nämlich herausgestellt, dass eine flächenparallele Lösung in vielen Fällen zu einem zu großen lateralen Platzbedarf auf der Platine führt und andererseits bei einer vertikalen Lösung oft zu große Bauhöhen erreicht werden. Indem von diesen fest vorgegebenen Winkeln abgewichen wird und eine Anwinkelung von mindestens 10° gegenüber der parallelen bzw. mindestens 20° gegenüber der senkrechten Lösung vorgenommen wird, können diese Nachteile vermieden werden, und zwar auf den Einzelfall angepasst entweder mehr auf den Platzbedarf auf der Platine oder mehr auf die Gesamtbauhöhe geachtet werden. Durch das Anwinkeln gegenüber der flächenparallelen Lösung kann überdies unter dem Kühlkörper bzw. bei an dessen der Schaltungsplatine zugewandten Seite anliegendem Bauelement unter diesem Bauelement Platz geschaffen werden, der im Einzelfall dann für anderes zur Verfügung steht. So können etwa flache Bauelemente wie SMD-Bauelemente in einem Teil der Fläche unter dem Kühlkörper bzw. dem gekühlten Bauelement angeordnet werden. Besonders bevorzugter Weise sind dort jedoch Leiterbahnen vorgesehen.

Die Anlagefläche des Kühlkörpers dient zum Wärmekontakt zwischen dem elektronischen Bauelement und dem Kühlkörper und sollte daher im Wesentlichen für eine flächige Anlage des Bauelements geeignet sein. Im Regelfall bedeutet dies, dass das Bauelement auf der entsprechenden Seite genauso wie die Anlagefläche im Wesentlichen eben ist. Im Einzelfall können aber auch andere Oberflächenformen Verwendung finden, solange ein guter Wärmeübergang gewährleistet ist.

Mit dem Begriff "Lampe" sind hier im Übrigen technische Strahlungsquellen verschiedenster Art gemeint, insbesondere auch Lampen, die nicht sichtbares Licht wie UV-Licht oder IR-Licht erzeugen, sowie Lampen, deren Licht nicht zur Beleuchtung an sich, etwa zur Innenraumbeleuchtung, dient sondern technische Funktionen anderer Art erfüllen. Mit dem Begriff "Betriebsschaltung" bzw. "Schaltung zum Betreiben einer Lampe" meint diese Beschreibung ferner jedweden Schaltungstyp, der die Lampe mit Leistung versorgt bzw. die Lampe und/oder ihre Versorgungsschaltung steuert. Vorzugsweise richtet sich die Erfindung dabei jedoch auf elektronische Vorschaltgeräte zum Betreiben von Lampen, insbesondere Entladungslampen oder Halogenglühlampen.

Vorzugsweise ist der Kühlkörper direkt auf derselben Schaltungsplatine montiert, auf der das elektronische Bauelement montiert ist. Dies kann vorzugsweise durch Schlitze in der Schaltungsplatine geschehen, die von Teilen des Kühlkörpers durchsetzt werden, etwa indem Montagebeine eines Metallblechkühlkörpers durch die Schlitze gesteckt werden. Weiterhin ist bevorzugt, dass der Kühlkörper durch ein Verbiegen der die Schlitze durchsetzenden Teile gesichert ist, etwa indem die Blechbeine auf der anderen Seite der Platine umgebogen, insbesondere verdreht werden. Dabei kann das die Schlitze zur Montage durchsetzende Kühlkörperteil auf Platinenhöhe eine Anlagekante aufweisen. Dadurch kann die Montagehöhe festgelegt werden, indem diese Anlagekante, etwa eine durch einen Einschnitt gebildete hinterschnittenen Kante, auf der Platine zur Anlage gebracht wird.

Bei einem elektrisch leitenden Kühlkörper, insbesondere einem Kühlkörper aus Metallblech, kann eine Kontaktierung über die Schlitze erfolgen, indem diese metallisiert und die Metallisierungen entsprechend angeschlossen werden. Dadurch kann der Kühlkörper beispielsweise zur Abschirmung eingesetzt werden.

Dabei richtet sich die Erfindung ferner vorzugsweise auf von einem evtl. Gehäuse freie Kühlkörper, die also nicht zur Wärmeleitung zu einem Gehäuse sondern "selbstständig" zur Kühlung dienen. Solche Kühlkörper können insbesondere in sog. "open frame"-Schaltungen ohne Gehäuse im eigentlichen Sinn Verwendung finden.

Die beschriebenen Winkel zwischen der Kühlkörperanlagefläche und der Schaltungsplatine zwischen 10° und 70° liegen vorzugsweise von den genannten Grenzen entfernt, und zwar insbesondere vorzugsweise nicht höher als 35°, besonders bevorzugter Weise nicht höher als 32° und im günstigsten Fall nicht über 30°. Aber auch die zwischen dem oberen Wert von 70° und dem Wert von 35° liegenden Zwischenwerte sind in entsprechender Reihenfolge als obere Grenze zunehmend bevorzugt, also etwa die Werte 60°, 50° und 40°. Weiterhin sind als untere Grenzen die Werte 15° bzw. 18° bzw. 20° in dieser Reihenfolge bevorzugt. Damit ergeben sich in vielen Fällen gute Gesamtbauhöhen bei insgesamt reduziertem lateralen Platzbedarf.

Es wurde bereits erwähnt, dass das elektronische Bauelement auf der "Oberseite" oder "Unterseite" vorgesehen sein kann. Dabei ist allerdings die Oberseite, d. h. die von der Schaltungsplatine abgewandte Seite, bevorzugt. I. d. R. ist hierbei die Montage einfacher und das Bauelement besser zugänglich. In Einzelfällen kann es, etwa wegen Abschirmungsproblemen oder anderem, aber auch zu umgekehrten Verhältnissen kommen.

Ferner ist bevorzugt, dass der Kühlkörper nicht nur für ein einzelnes elektronischen Bauelement sondern für eine Mehrzahl vorgesehen ist und diese Bauelemente dabei in einer Reihe angeordnet sind. Die Richtung der Reihenanordnung liegt dabei im Wesentlichen parallel zu der Schaltungsplatinenebene und senkrecht zu der Neigungsrichtung (also dem Gradienten) der schräg stehenden Anlagefläche.

Schließlich ist eine Klammerung des Bauelements über eine elastische Feder an die Anlagefläche bevorzugt. Im Prinzip sind jedoch auch andere Montagemöglichkeiten denkbar. Insbesondere kann es wegen besonderer Vibrations- oder Erschütterungsprobleme oder zu Gunsten eines besonders guten Wärmekontakts notwendig sein, eine sehr feste Verbindung vorzusehen, wobei dann ein Anschrauben oder Annieten des Bauelements bevorzugt ist. Dabei kann natürlich für das Anbringen der Schraube oder das Annieten ein Hilfsmittel verwendet werden, etwa ein anzuschraubendes oder anzunietendes Klemmblech. Mit Anschrauben oder Annieten ist hier gemeint, dass der für die Anlage wesentliche Druck durch das Schraubgewinde bzw. die Nieten und keine wesentliche Eigenelastizität wie bei einer Feder vorliegt.

Die bevorzugte Feder wiederum kann an dem Kühlkörper angesteckt sein, also insbesondere in eine Lasche eingeführt oder durch einen auf die entgegengesetzte Seite des Kühlkörpers führenden Schlitz hindurchgesteckt sein. Die Feder kann dann durch einen einfachen Formschluss ohne weitere Befestigungsmaßnahmen ihre Funktion ausüben.

Eine Schraubverbindung kommt aber auch für die elastische Feder selbst in Betracht, um sie besonders gut zu sichern. Sie ist dabei vorzugsweise auf der Oberseite des Kühlkörpers, also auf der der Schaltungsplatine abgewandten Seite, angeschraubt. Bei der Herstellung kann solch eine Schraubverbindung auch durch einen Schraubautomaten erfolgen.

Auch die Feder selbst kann noch als Kühlmöglichkeit mitbenutzt werden. Dazu weist sie vorzugsweise zumindest einen aufgebogenen Flächenabschnitt auf, etwa einen an den das Bauelement fassenden Teil anschießenden aufgebogenen Abschnitt. Hierdurch kann sich die Gesamtoberfläche für die Wärmeleitung und Wärmestrahlung durch die Feder vergrößern und bei geeigneter Biegung trotzdem eine Anpassung an die gewünschte Gesamtbauhöhe oder laterale Baugröße beibehalten werden. Es wird zur Veranschaulichung auf das Ausführungsbeispiel verwiesen.

Der Kühlkörper kann auch mehr als eine schräg verlaufende Anlagefläche, insbesondere zwei Anlageflächen aufweisen, die jeweils einen spitzen Winkel mit der Schaltungsplatine einschließen. Vorzugsweise grenzen diese Anlageflächen dann "giebelartig" aneinander, wobei also die Grenzlinie zwischen den Anlageflächen quer zur Neigungsrichtung verläuft bzw. die Anlageflächen in Neigungsrichtung aneinandergrenzen.

Dabei kann eine der beiden Seiten beispielsweise zur Befestigung elastischer Federn genutzt werden oder können auch beide Anlageflächen für die Anlage von zu kühlenden Bauelementen genutzt werden. Diese liegen dabei vorzugsweise in alternierender Reihe, wobei sich günstige Möglichkeiten für die Unterbringung von Federn zur Befestigung der Bauelemente ergeben.

Im Folgenden wird die Erfindung anhand von Ausführungsbeispielen näher erläutert, wobei dabei dargestellte Merkmale auch in anderen Kombinationen erfindungswesentlich sein können. Im Übrigen bezieht sich die vorstehende und die folgende Beschreibung gleichzeitig auf den Vorrichtungscharakter und den Verfahrenscharakter der Erfindung, ohne dass dies im Einzelnen in der Beschreibung unterschieden wird.

### Kurze Beschreibung der Zeichnungen

- Fig. 1: zeigt eine schematische Seitenansicht einer erfindungsgemäßen Schaltung.
- Fig. 2: zeigt eine perspektivische Ansicht eines erfindungsgemäßen Kühlkörpers.
- Fig. 3: zeigt eine schematische Seitenansicht eines weiteren Ausführungsbeispiels einer erfindungsgemäßen Schaltung.
- Fig. 4 und 5: zeigen in Draufsicht Details zu einer Feder des Ausführungsbeispiels aus Fig. 3.
- Fig. 6: zeigt ein Detail zur Montage der Kühlkörper aus den Fig. 1 bis 3 auf einer Schaltungsplatine.

### Bevorzugte Ausführung der Erfindung

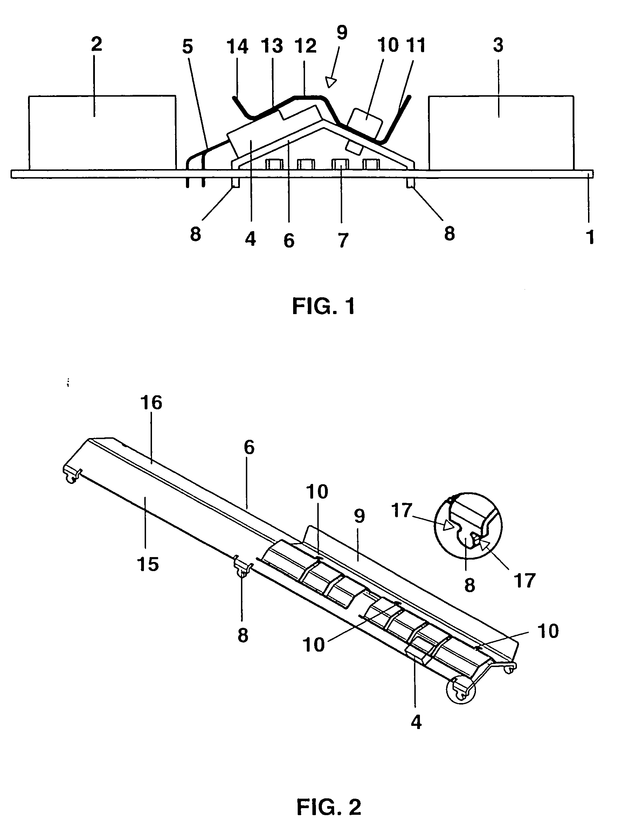

Fig. 1 zeigt eine an sich übliche Schaltungsplatine 1 eines elektronischen Vorschaltgeräts für eine Entladungslampe, in diesem Fall für eine nach dem Prinzip der dielektrische behinderten Entladung arbeitende flache Lampe zur Hinterleuchtung von LCD-Monitoren. Auf der Schaltungsplatine 1 sind hier nicht näher erläuterte elektronische Bauelemente 2 und 3 montiert und ferner ein Leistungstransistor 4, der ein zu kühlendes elektronisches Bauelement bildet. Der Leistungstransistor 4 ist über mit 5 bezeichneten Kontaktbeinchen an Leiterbahnen auf der Schaltungsplatine 1 angeschlossen und würde konventioneller Weise entweder senkrecht nach oben stehen oder waagrecht zur Seite weggebogen sein. In diesem Fall ist er jedoch in einem Winkel von 25° zu der Schaltungsplatine 1 geneigt und mit seiner planen Unterseite auf eine ebenfalls unter 25° zur Schaltungsplatine 1 orientierte Anlagefläche eines Kühlkörpers 6 aufgelegt.

Der Kühlkörper 6 hat einen im Wesentlichen giebelförmigen Querschnitt mit zwei zueinander spiegelbildlichen und jeweils unter 25° zur Schaltungsplatine 1 orientierten Hälften, die jeweils nach oben Anlageflächen im Sinn der Erfindung bilden. Er lässt unter sich einen entsprechenden Hohlraum frei, der für weitere flache Schaltungselemente 7 genutzt werden kann, etwa Leiterbahnen, SMD-Bauelemente o. Ä.

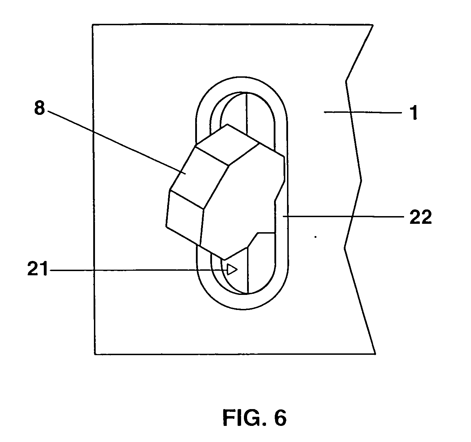

Der Kühlkörper 6 besteht aus üblichem Metallblech, wie es auch sonst für Kühlkörper Verwendung findet und ist über hier nur symbolisch dargestellte Montagebeine 8 auf der Schaltungsplatine 1 verankert. Die Montagebeine 8 sind in metallisierten und elektrisch angeschlossenen Schlitzen der Schaltungsplatine 1 gehalten, so dass der Kühlkörper 6 mit der Schaltungsmasse verbunden ist. Es wird auf Fig. 6 verwiesen.

Der Kühlkörper 6 nach diesem Ausführungsbeispiel weist zwei Anlageflächen auf, die in Fig. 1 jeweils nach links oben bzw. rechts oben weisen. Auf der linken oberen Anlagefläche liegt der Leistungstransistor 4 auf, während auf der rechten oberen Anlagefläche eine elastische Feder 9 mit einer Schraube 10 in einem Gewinde in dem Kühlkörper 6 angeschraubt ist.

Die elastische Feder 9 weist in Fig. 1 rechts von der Schraube 10 einen rechtwinklig aufgebogenen Abschnitt 11 auf und geht links von der Schraube 10 in einen im Wesentlichen schaltungsplatinenparallelen Abschnitt 12 über, der seinerseits in einen Abschnitt 13 übergeht, der mit der Schaltungsplatine 1 einen etwas größeren Winkel bildet als die Anlagefläche des Kühlkörpers 6. Deswegen liegt der untere Teil dieses Abschnitts 13 auf der zu der Unterseite des Leistungstransistors 4 parallelen Oberseite an und bildet einen definierten Anlagebereich für die Klemmfunktion. Von diesem Anlagebereich aus ist die elastische Feder 9 wiederum etwa um 90° zu dem Abschnitt 13 nach oben weggebogen zu einem weiteren aufgebogenen Abschnitt 14. Der aufgebogene Abschnitt 11 dient zur Vergrößerung der für die Kühlfunktion wesentlichen Oberfläche der Feder 9 und auch zur Handhabung der Feder bei der Montage der Feder selbst. Der Abschnitt 12 ist gegenüber den rechts und links angrenzenden Abschnitten deswegen flach gestaltet, um die Gesamtbauhöhe nicht zu übersteigen, die auch nicht von den aufgebogenen Abschnitten 11 und 14 überschritten wird. Die Gesamtkonstruktion ist also nur unwesentlich höher als die in Fig. 1 erkennbare rechte obere Kante des Leistungstransistors 4. Der aufgebogene Abschnitt 14 dient zum einen wiederum zur Vergrößerung der Federoberfläche und zum anderen auch dazu, die Feder besser über den Leistungstransistor 4 schieben zu können.

Die Schraubbefestigung über die Schraube 10 hat den Vorteil einer sehr zuverlässigen mechanischen Befestigung, die insbesondere vibrationssicher ist und einen dauerhaften elektrischen Kontakt auch zu der Feder 9 sicherstellt. Auch diese kann an der Abschirmungsfunktion, die hinsichtlich der elektrischen Kontaktierung des Kühlkörpers selbst erwähnt wurde, teilnehmen.

Fig. 2 zeigt in perspektivischer Darstellung den Kühlkörper 6 aus Fig. 1 mit den beiden hier mit 15 und 16 bezeichneten Anlageflächen sowie, hier ausführlicher dargestellt, die Montagebeine 8 des Kühlkörpers 6. Die in dem rechten Kreis in Fig. 2 enthaltene vergrößerte Darstellung zeigt, dass diese Montagebeine 8 Einschnitte 17 haben, die in montiertem Zustand auf Höhe der Schaltungsplatine 1 zu liegen kommen.

Die sich an die Einschnitte 17 nach oben anschließenden Kanten der Beine kommen zur Anlage auf der Schaltungsplatine 1. Es wird wiederum auf Fig. 6 verwiesen.

Fig. 2 zeigt ferner die elastische Feder 9, die wie Fig. 2 deutlich veranschaulicht, in der auf der Zeichenebene der Fig. 1 senkrechten Richtung lang gestreckt ausgebildet ist und hinsichtlich der Abschnitte 12, 13 und 14 mehrere einzelne Federabschnitte zur Befestigung mehrerer Bauelemente 4 bietet. Ein Bauelement ist in Fig. 2 beispielhaft angedeutet, wohingegen die übrigen Plätze freigelassen sind. Man erkennt, dass der in Fig. 2 dargestellte Kühlkörper zwei der dargestellten Federn 9 tragen kann, wobei nur eine eingezeichnet ist, und jede Feder 9 größenordnungsmäßig fünf bis zehn Bauelemente 4 halten kann, wobei die speziell dargestellte Feder 9 in Folge verbreiterter Außenabschnitte und eines vergrößerten Abstands zwischen einzelnen Federelementen in der Mitte insgesamt für sieben separat zu montierenden Bauelemente 4 unterschiedlicher Dicke ausgelegt ist. In den verbreiterten Abschnitten können aber auch zwei oder mehr Bauelemente jeweils gleicher Dicke montiert werden.

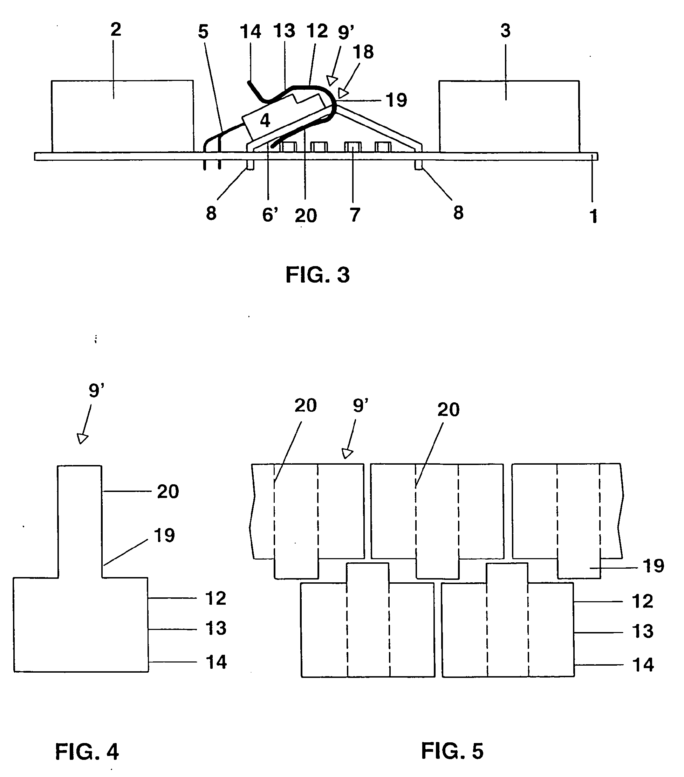

Fig. 3 zeigt eine alternative Ausführungsform in einer Fig. 1 angenäherten Darstellung. Entsprechende Elemente und Merkmale sind analog beziffert. Im Unterschied zu Fig. 1 weist der Kühlkörper 6' hier allerdings einen im Giebel liegenden Schlitz 18 auf, durch den ein an den horizontalen Abschnitt 12 der Feder 9' anschließender etwa um 180° gekrümmter Abschnitt 19 der Feder hindurchgeführt wird. Dieser Abschnitt 19 der Feder 9' geht über in einen leicht (von unten besehen) konkaven Abschnitt 20, der die Unterseite der Anlagefläche 15 des Kühlkörpers 6' hintergreift und somit ein Klemmen des Bauelements 4 durch den Abschnitt 13 auf der anderen Seite ermöglicht. Die Feder 9' kann also mit ihrer insgesamt U-ähnlichen Form durch den Schlitz 18 hindurchgesteckt werden und erlaubt damit eine Montage ohne gesonderte Schraubbefestigung. Ferner nimmt sie nur die linke Hälfte des Kühlkörpers 6' ein.

Insgesamt handelt es sich bei der Schaltung aus den Fig. 1 und 3 jeweils um eine sog. "open frame"-Schaltung, die also nur auf einer Platine 1 ohne weiteres umschließendes Gehäuse aufgebaut ist.

Fig. 4 zeigt zum Verständnis das zur Herstellung der Feder 9' dienende Blech in flachem Zustand von oben gesehen und veranschaulicht, dass die Feder 9' im Bereich der Abschnitte 19 und 20 deutlich schmaler als im Bereich der übrigen Abschnitte 12, 13 und 14 ist. Damit können auf einem im Übrigen dem Kühlkörper 6 aus Fig. 2 entsprechenden, jedoch mit einem Schlitz 18 versehenen Kühlkörper 6' auf beiden Anlageflächen 15 und 16 Bauelemente 4 montiert werden, wobei die Federn 9' so angebracht werden, wie dies Fig. 5 schematisch verdeutlicht. Sie liegen nämlich in Giebelrichtung alternierend, so dass die von ihnen gehaltenen Bauelemente im Wesentlichen dicht liegen können. In Fig. 5 bezeichnen die gestrichelten Linien die von den darüber liegenden Abschnitten 12, 13 und 14 verdeckten Abschnitte 20. Die Schraffierungen deuten die Krümmungen an.

Fig. 6 zeigt schematisch die Befestigung der Kühlkörper 6 und 6' aus den Figuren 1 bis 3 auf der Schaltungsplatine 1. Die bereits erwähnten Montagebeine 8 sind durch mit 21 bezeichnete Schlitze hindurch gesteckt und durch ein verdrehendes Verbiegen auf der Unterseite der Schaltungsplatine 1 verriegelt. Fig. 6 zeigt dabei eine Unteransicht der Schaltungsplatine 1 und den untersten Bereich eines Montagebeins 8. Die in Fig. 2 gezeigten Einschnitte 17 nehmen den größten Teil der Verbiegung auf, so dass der darunter liegende "Kopf" den Kühlkörper 6 gegen ein Wiederherausziehen sperrt. Dabei kommt das Schaltungsbein 8 in elektrischen Kontakt mit einer Metallisierung 22 auf der Unterseite des Schlitzes, die jedoch auch auf den Innenseiten des Schlitzes und der Oberseite vorhanden ist und an eine Leiterbahn angeschlossen ist. Diese Montage hat sich als besonders einfach und zeitsparend und hinsichtlich der plastischen Verformung des Montagebeins 8 und dem damit erfolgten Verklemmen auch als für den elektrischen Kontakt zwischen dem Montagebein 8 und der Metallisierung 22 ausreichend herausgestellt. Ferner kann sich das Montagebein 8 bei unterschiedlicher Wärmeausdehnung des Kühlkörpers 6 und der Schaltungsplatine 1 notfalls etwas innerhalb des Schlitzes 21 bewegen, was in Anbetracht der aus Fig. 2 ersichtlichen erheblichen Länge des Kühlkörpers 6 im Vergleich zu seiner Breite für gute thermische Eigenschaften sorgt. In der Querrichtung wiederum ist der gesamte Kühlkörper 6 etwas elastisch und kann damit thermische Ausdehnungsunterschiede ausgleichen.

Die Erfindung erzielt damit insgesamt nicht nur eine deutlich verringerte Bauhöhe, die sich im Einzelfall auch an den elektronischen Bauelementen 2 und 3 in der Umgebung orientieren kann, sondern darüber hinaus auch geringe Stückkosten der Teile und eine einfache und damit preiswerte Montierbarkeit. Der laterale Platzbedarf ist gegenüber einer horizontalen Geometrie verringert, wobei zusätzlich noch Bestückungsmöglichkeiten und Möglichkeiten zur Leiterbahnführung unterhalb des Kühlkörpers erzielt werden können. Der Kühlkörper lässt sich überdies durch die geschilderte Montage auch leicht elektrisch kontaktieren. Schließlich dient er bei Bedarf auch zur mechanischen Stabilisierung der Montageplatine.

## Patentansprüche

1. Elektrische Schaltung zum Betreiben einer Lampe,
welche Schaltung aufweist:
zumindest ein elektronisches Bauelement (4), das im Betrieb Betriebswärme erzeugt,
eine Schaltungsplatine (1), auf der das elektronische Bauelement (4) montiert ist,
und einen Kühlkörper (6, 6') zum Ableiten der Betriebswärme aus dem elektronischen Bauelement (4),
wobei das elektronische Bauelement (4) flächig an einer Anlagefläche (15, 16) des Kühlkörpers (6, 6') anliegt,
**dadurch gekennzeichnet, dass** die Anlagefläche (15, 16) mit der Schaltungsplatine (1) einen Winkel von 10° - 70° einschließt.

2. Schaltung nach Anspruch 1, bei der der Kühlkörper (6, 6') direkt auf der Schaltungsplatine (1) montiert ist.

3. Schaltung nach Anspruch 2, bei der der Kühlkörper (6, 6') Schlitze in der Schaltungsplatine (1) durchsetzt, die gegenüber den sie jeweils durchsetzenden Teilen (8) des Kühlkörpers (6, 6') Übermaß haben.

4. Schaltung nach Anspruch 3, bei der der Kühlkörper (6, 6') durch die Schlitze gesteckt und durch Verbiegen darin gesichert ist.

5. Schaltung nach Anspruch 4, bei der die die Schlitze jeweils durchsetzenden Teile des Kühlkörpers (6, 6') auf der Höhe der Schaltungsplatine (1) eine Anlagekante aufweisen.

6. Schaltung nach einem der Ansprüche 3 - 5, bei der die Schlitze in der Schaltungsplatine (1) metallisiert sind und der Kühlkörper (6, 6') aus elektrisch leitendem Material besteht und über die Metallisierungen in den Schlitzen elektrisch kontaktiert ist.

7. Schaltung nach einem der vorstehenden Ansprüche, bei der der Winkel zwischen der Anlagefläche (15, 16) und der Schaltungsplatine (1) höchstens 35°, vorzugsweise höchstens 32° und besonders bevorzugter Weise höchstens 30° beträgt sowie vorzugsweise zumindest 15°, besonders bevorzugter Weise zumindest 18° und ganz besonders bevorzugter Weise zumindest 20° beträgt.

8. Schaltung nach einem der vorstehenden Ansprüche, bei der die Anlagefläche (15, 16) an einer der Schaltungsplatine (1) entgegengesetzten Seite des Kühlkörpers (6, 6') vorgesehen ist.

9. Schaltung nach einem der vorstehenden Ansprüche, bei der die Schaltungsplatine (1) unter dem Kühlkörper (6, 6') zumindest eine Leiterbahn aufweist.

10. Schaltung nach einem der vorstehenden Ansprüche, bei der eine Mehrzahl elektronischer Bauelemente (4) in einer Reihe entlang einer zu der Neigungsrichtung der Anlagefläche (15,16) senkrechten und zu der Schaltungsplatine (1) parallelen Richtung an der Anlagefläche (15, 16) des Kühlkörpers (6, 6') anliegen.

11. Schaltung nach einem der vorstehenden Ansprüche, bei der das elektronische Bauelement (4) über eine elastische Feder (9, 9') an die Anlagefläche (15, 16) geklammert ist.

12. Schaltung nach Anspruch 11, bei der die elastische Feder (9) an dem Kühlkörper (6) angeschraubt ist.

13. Schaltung nach Anspruch 11, bei der die elastische Feder (9') an dem Kühlkörper (6') angesteckt ist.

14. Schaltung nach einem der Ansprüche 11 - 13, bei der die elastische Feder (9, 9') zumindest einen gegenüber der Anlagefläche (16) des Kühlkörpers (6, 6') aufgebogenen Abschnitt (11, 14) aufweist.

15. Schaltung nach einem der vorstehenden Ansprüche, bei der der Kühlkörper (6, 6') zwei in Neigungsrichtung aneinandergrenzende Anlageflächen (15, 16) aufweist, die jeweils mit der Schaltungsplatine (1) einen spitzen Winkel einschließen.

16. Schaltung nach Anspruch 15, bei der an beiden Anlageflächen (15, 16) elektronische Bauelemente (4) anliegen.

17. Schaltung nach Anspruch 16, bei der die elektronischen Bauelemente (4) an den beiden Anlageflächen (15, 16) in alternierender Reihe anliegen.

18. Verfahren zum Montieren eines im Betrieb Betriebswärme erzeugenden elektronischen Bauelements (4) in einer elektrischen Schaltung zum Betreiben einer Lampe,
welche Schaltung einen Kühlkörper (6, 6') zum Ableiten der Betriebswärme aus dem elektronischen Bauelement (4) aufweist,
wobei das elektronische Bauelement (4) flächig an einer Anlagefläche (15, 16) des Kühlkörpers (6, 6') angelegt wird,
**dadurch gekennzeichnet, dass** die Anlagefläche (15, 16) mit der Schaltungsplatine (1) einen Winkel von 10° - 70° einschließt.
